Europäisches Patentamt

European Patent Office

Office européen des brevets

(11) Veröffentlichungsnummer: **0 415 382 A2**

# EUROPÄISCHE PATENTANMELDUNG

(21) Anmeldenummer: 90116563.9

(22) Anmeldetag: 29.08.90

(51) Int. Cl.5: **G02B 6/12**

(30) Priorität: 31.08.89 DE 3928894
29.01.90 DE 4002490

(43) Veröffentlichungstag der Anmeldung:
**06.03.91 Patentblatt 91/10**

(84) Benannte Vertragsstaaten:
**AT BE CH DE DK ES FR GB GR IT LI LU NL SE**

(71) Anmelder: **Bodenseewerk Gerätetechnik GmbH**
**Alte Nussdorfer Strasse 15 Postfach 1120**
**W-7770 Überlingen/Bodensee(DE)**

(72) Erfinder: **Froning, Edilbert Alexander**
**Bodanstrasse 23**
**W-7772 Oberuhldingen(DE)**
Erfinder: **Langner, Klaus Alexander**
**Alte Dorfstrasse 61**
**W-7770 Ueberlingen(DE)**

(74) Vertreter: **Weisse, Jürgen, Dipl.-Phys. et al**
**Bökenbusch 41 Postfach 11 03 86**
**W-5620 Velbert 11-Langenberg(DE)**

(54) Verfahren zum Anbringen von elektrooptischen Bauteilen an integriert-optischen Wellenleitern.

(57) Ein Verfahren zur Anbringung von elektrooptischen Bauteilen (20) an integriertoptischen Wellenleitern (12), die in einem Substrat (10) vorgesehen sind, enthält die Verfahrensschritte: (a) Aufbringen eines Ätzmittels auf das Substrat (10) so, daß in die Oberfläche des Substrats eine Grube (18) eingeätzt wird, welche einen Wellenleiter (12) anschneidet, (b) Positionieren und Haltern eines zu montierenden elektrooptischen Bauteils (20) in der Grube (18) in der gewünschten Position zu dem Wellenleiter (12) und (c) Vergießen des Bauteils (20) in der Grube (18) mit einem sich verfestigenden Material von einem an den Brechungsindex des Wellenleiters angepaßten Brechungsindex. Bei anderen Ausführungen wird die Grube durch Bohren oder Fräsen hergestellt.

Fig. 1

EP 0 415 382 A2

Die Erfindung betrifft ein Verfahren zur Anbringung von elektrooptischen Bauteilen an integriert-optischen Wellenleitern, die in einem Substrat vorgesehen sind.

## Zugrundeliegender Stand der Technik

Zum Herstellen von integriert-optischen Wellenleitern wird ein Substrat, üblicherweise aus Glas, mit einer Metallmaske abgedeckt. Die Struktur der Metallmaske, z.B. so daß die Bahnen der herzustellenden Wellenleiter frei bleiben, wird durch eine Photoätztechnik erzeugt. Durch Ionenaustausch wird dann der Brechungsindex des Substrats in den von der Maske freigelassenen Bereichen erhöht. Es ist erforderlich, diese Wellenleiter mit elektrooptischen Bausteinen optisch zu koppeln, also mit Lichtsendern oder photoelektrischen Empfängern. Es ist bekannt, diese Kopplung durch lichtleitende Fasern herzustellen. Dieses Verfahren bringt aber in der Praxis erhebliche Probleme mit sich.

Die DE-OS 37 31 311 betrifft einen kombinierten Sende- und Empfangsbaustein eines bidirektionalen optischen Übertragungssystems mit einer an eine Übertragungsfaser gekoppelten Lichtwellenleiterstruktur auf der Oberfläche einer Siliziumplatte. Ein plattenförmiges Bauelement mit einer Sendediode befindet sich ebenfalls auf der Oberfläche der Siliziumplatte und ist über eine Kugellinse an die Lichtwellenleiterstruktur gekoppelt. Ein weiteres plattenförmiges Bauelement mit einer Empfangsdiode ist ebenso auf der Oberfläche der Siliziumplatte angeordnet und ist über eine verspiegelte Schrägfläche an einen gekrümmten Ast der Lichtwellenleiterstruktur gekoppelt.

Die DE-OS 33 43 558 betrifft eine opto-elektrische Koppelanordung in Verbindung mit einem Trägerelement aus einer Glas- oder Keramikplatte. Auf der Oberfläche des Trägerelementes befindet sich ein elektrisches Bauelement, das durch einen Bonddraht mit einem Photodetektor verbunden ist. Der Photodetektor befindet sich auf einem Kontaktring, der auf der Oberfläche des Trägerelementes angeordnet ist. Durch einen Durchbruch im Trägerelement und ein Umlenkelement ist der Photodetektor an einen Lichtwellenleiter in einer V-förmigen Vertiefung gekoppelt, die in dem Trägerelement ausgebildet ist.

Die US-PS 4 756 702 betrifft ein in das Innere eines Glaskörpers integriertes optisches Bauelement, das an gegenüberliegenden Enden des Glaskörpers an Fasern angekoppelt ist. Das in den Glaskörper eingeschlossene ("buried") Bauelement wird in dem Glaskörper durch ein Ionenaustauschverfahren erzeugt.

## Offenbarung der Erfindung

Der Erfindung liegt die Aufgabe zugrunde, an integriertoptischen Wellenleitern elektrooptische Bauteile, also Lichtsender oder photoelektrische Enpfänger, mit einfachen, technisch bequem beherrschbaren Mitteln so anzubringen, daß sie mit geringen Lichtverlusten mit den Wellenleitern optisch gekoppelt sind.

Erfindungsgemäß wird diese Aufgabe gelöst durch die Verfahrensschritte

(a) Herstellen einer Grube, die einen Wellenleiter anschneidet, in der Oberfläche des Substrats,

(b) Positionieren und Haltern eines zu montierenden elektrooptischen Bauteils in der Grube in der gewunschten Position zu dem Wellenleiter und

(c) Vergießen des Bauteils in der Grube mit einem sich verfestigenden Material.

Die Erfindung kann in der Weise verwirklicht werden, daß zum Herstellen der Grube ein Ätzmittel auf die Oberfläche des Substrats aufgebracht wird.

Die Aufbringung des Ätzmittels kann unter einer einfachen Lupe vorgenommen werden. Die Ätzung der Grube geschieht in Abhängigkeit von Zeit und Temperatur und kann durch Abspülen mit Wasser gestoppt werden. Die Ätzung ergibt eine recht saubere Ätzkante. Die elektrooptischen Bauteile werden im Strahlengang des Wellenleiters justiert und durch das sich verfestigende Material sauber in der justierten Stellung fixiert. Das sich verfestigende Material gewährleistet gleichzeitig durch Wahl des Brechungsindex den verlustarmen Übergang des Lichts zwischen Wellenleiter und elektrooptischem Baustein.

Auf die Oberfläche des Substrats kann um den Bereich der Grube herum eine von dem Ätzmittel nicht angegriffene Schicht aufgebracht und der Ätzvorgang so durchgeführt werden, daß eine Unterätzung stattfindet, derart, daß die Grube unterhalb der besagten Schicht einen überhängenden Wandungsteil aufweist. Der Wellenleiter endet dann in diesem überhängenden Wandungsteil.

Das erfindungsgemäße Verfahren kann aber auch in der Weise realisiert werden, daß die Grube durch mechanische Bearbeitung des Substrats hergestellt wird.

Dabei kann die Grube durch Bohren oder durch Fräsen hergestellt werden.

Mit einem Fräswerkzeug kann eine zylinderabschnittförmige Grube mit zwei zueinander parallelen, ebenen Stirnflächen senkrecht zur Oberfläche des Substrats gefräst werden.

Bei der Herstellung der Wellenleiter durch Ionenaustausch, wobei die Oberfläche des Substrats durch eine Metallschicht abgedeckt und diese Metallschicht nach Herstellung der Wellenleiter weggeätzt wird, können neben der Position der zu montierenden elektrooptischen Bauteile Teile der Metallschicht vor dem Wegätzen abgedeckt werden, so daß die so stehenbleibenden Teile der Metallschicht Bondflächen bilden, mit denen Bonddrähte der elektrooptischen Bauteile verbunden werden.

Das sich verfestigende Material kann ein Kunstharz sein. Das sich verfestigende Material kann aber auch Silikon kautschuk sein. Für manche Anwendungen ist es vorteilhaft, wenndas sich verfestigende Material ein niedrigbrechender, optischer, UV-gestarteter Kleber ist.

W enn der elektrooptische Bauteil ein Laserchip mit einer Wärmesenke ist, kann der Laserchip kopfstehend mit der Wärmesenke so auf das Substrat aufgeklebt werden, daß er in den Wellenleiter einstrahlt.

Die Montage des Lasers kann in der Weise erfolgen daß der Laser mittels eines Mikromanipulators positioniert wird und bei der Positionierung die Einkopplungsintensität des Lasers beobachtet wird. Die Justage kann dann in Abhängigkeit von der beobachteten Einkopplungsintensität so erfolgen, daß eine optimale Einkopplungsintensität erzielt wird.

Um den Reflexionsgrad an den Endflächen des Lasers nicht in unerwünschter Weise durch den Brechungsindex einer Vergußmasse zu vermindern, ist es vorteilhaft, wenn der Laser nur an der Wärmesenke verklebt und unter Lufteinschluß verkapselt wird.

Zur Erzielung eines hohen Koppelwirkungsgrades sollte der Laser auf weniger als 5µ an die Stirnfläche des Wellenleiters herangerückt werden.

Zur Herstellung einer integrierten Optik mit einem Laser mit externem Resonanzraum kann der Laser zur Teilentspiegelung im Bereich seiner vorderen Facette mit einer Vergußmasse umgossen werden, deren Brechungsindex an den Brechungsindex des Wellenleiters angepaßt ist. Die Rückseite sollte dann zusätzlich verspiegelt werden.

Zur Herstellung einer integrierten Optik mit einem Laser mit externem Resonanzraum kann der Laser aber auch auf seiner Rückseite verspiegelt und der Wellenleiter zu einem externen Spiegel geführt werden. Dabei kann zur Bildung des externen Spiegels eine Endfläche des Substrats verspiegelt werden, zu welcher der Wellenleiter führt.

Das elektrooptische Bauteil kann eine Photodiode aufweisen. Das elektrooptische Bauteil kann aber auch eine Leuchtdiode aufweisen. Die Photodiode oder Leuchtdiode können Teile eines Chips bilden.

Ausführungsbeispiele der Erfindung sind nachstehend unter Bezugnahme auf die zugehörigen Zeichnungen näher erläutert.

## Kurze Beschreibung der Zeichnungen

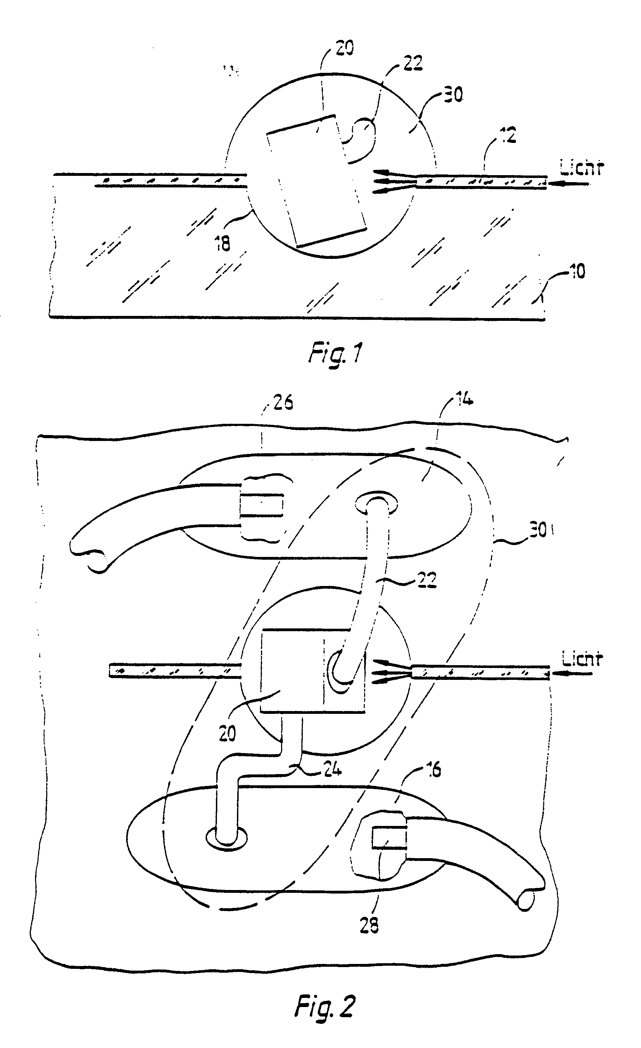

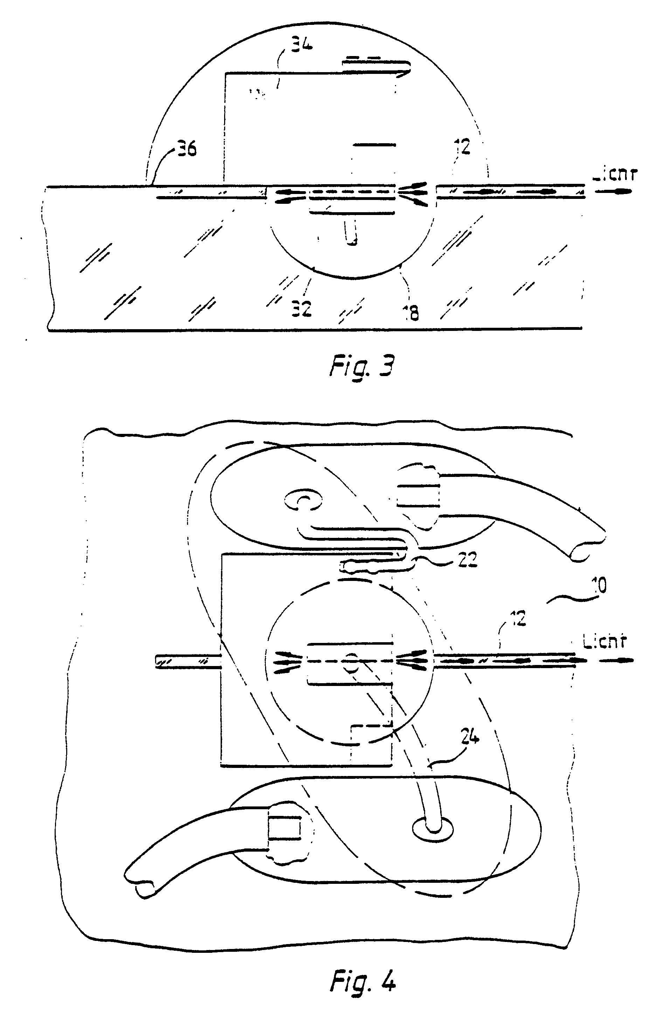

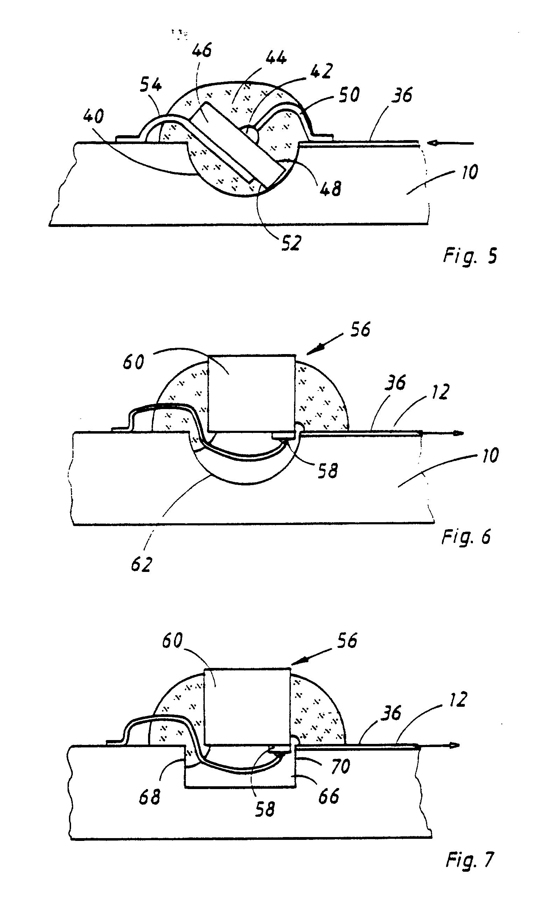

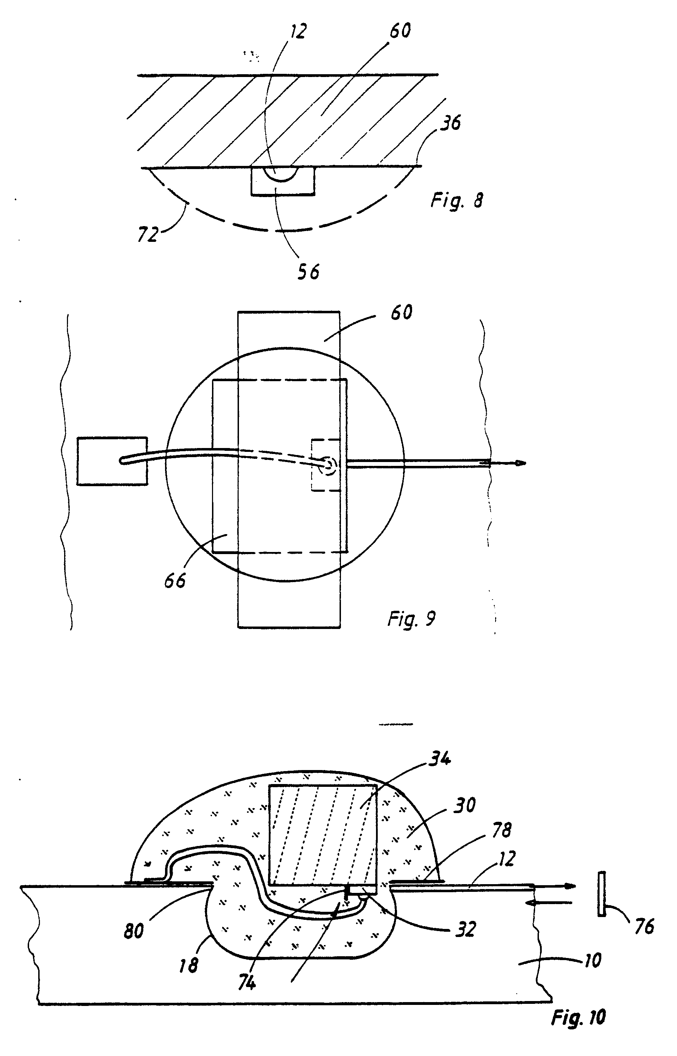

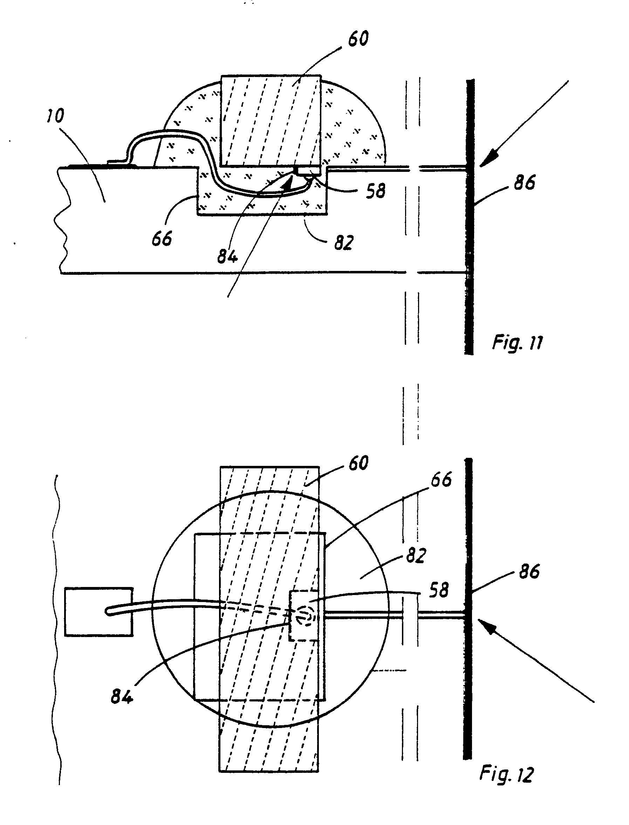

Fig.1 ist eine schematische Seitenansicht eines elektrooptischen Bauteils, der an einen integriert- optischen Wellenleiter angekoppelt ist. Fig.2 ist eine abgebrochen dargestellte Draufsicht auf das Substrat mit dem Wellenleiter und dem elektrooptischen Bauteil. Fig.3 ist eine schematische Seitenansicht einer Anordnung, bei welcher ein mit einer Wärmesenke versehener Laser an einen Wellenleiter angekoppelt wird. Fig.4 ist eine abgebrochene Draufsicht der Anordnung von Fig.3. Fig.5 zeigt die Anordnung einer Photodiode ähnlich Fig. 1, die in einer durch mechanische Bearbeitung erhaltenen Grube angeordnet und mit einem Wellenleiter optisch gekoppelt ist. Fig .6 zeigt einen Halbleiterlaser mit Wärmesenke ähnlich Fig. 3, der in einer durch Bohren hergestellten Grube angeordnet und mit einem Wellenleiter gekoppelt ist. Fig .7 zeigt die Anordnung eines Halbleiterlasers ähnlich Fig .6 in einer durch Querfräsung erzeugten Grube. Fig.8 zeigt eine Ansicht des Wellenleiters, des Lasers, der Grube und der Wärmesenke von rechts in Fig .7 gesehen. Fig.9 ist eine zugehörige Draufsicht. Fig. 10 zeigt eine integrierte Optik mit einem Laser mit externem Resonanzraum. Fig. 11 zeigt eine andere Anordnung mit einem Laser und externem Resonanzraum. Fig. 12 zeigt eine zugehörige Draufsicht.

## Bevorzugte Ausführungen der Erfindung

Mit 10 ist ein Glassubstrat bezeichnet. In dem Glassubstrat wird ein Wellenleiter 12 erzeugt, indem das Glassubstrat mit einer Metallschicht abgedeckt wird. Diese Metallschicht wird durch ein Photoätzverfahren so behandelt, daß die Bahn des Wellenleiters 12 frei bleibt und die Oberfläche des Substrats 10 im übrigen abgedeckt wird. Durch Ionenaustausch wird der Brechungsindex des Glases im Bereich der freiliegenden Oberflächenteile erhöht, so daß sich der Wel lenleiter 12 ausbildet. Nach diesem Ionenaustausch wird die Metallschicht weggeätzt. Das ist ein bekanntes Verfahren und daher hier nicht im einzelnen beschrieben.

Vor dem Wegätzen der Metallschicht werden jedoch Flächenteile 14 und 16 abgedeckt. Diese Flächenteile 14 und 16 liegen beiderseits der Stelle, wo ein elektrooptisches Bauteil an den Wellenleiter 12 angekoppelt werden soll, also entweder ein Lichtsender oder ein photoelektrischer Empfänger. Die Flächenteile 14 und 16 werden daher beim Wegätzen der Metallschicht nicht mit weggeätzt sondern bleiben stehen. Die Metallschicht in diesen Flächenteilen 14 und 16 bildet Bondkontakte für das elektrooptische Bauteil.

Zwischen den beiden Flächenteilen 14 und 16 wird ein Tropfen eines Ätzmittels aufgebracht. Bei einem Glassubstrat ist das Ätzmittel Flußsäure (HF). Dieses Ätzmittel ätzt in die Oberfläche des Substrats 10 eine Grube 18. Die Tiefe der Grube kann durch Zeit und Temperatur bestimmt werden. Nach Erreichen einer gewünschten Tiefe der Grube 18 wird der Ätzvorgang unterbrochen. Das kann durch Abspülen mit Wasser geschehen. Die Grube schneidet den Wellenleiter 12 an. In diese Grube wird nun ein elektrooptisches Bauteil 20 eingesetzt. Das kann beispielsweise eine Leuchtdiode sein oder eine Photodiode. Das Bauteil wird mit seinen Bonddrähten 22 und 24 an die Bondkontakte angebondet, die von der in den Flächenteilen 14 und 16 stehengebliebenen Metallschicht gebildet sind. Der Anschluß des elektrooptischen Bauteils geschieht in konventioneller Weise durch Leitkleber 26 und 28.

Das elektrooptische Bauteil 20 wird dann zu dem Strahlengang des Wellenleiters 12 ausgerichtet. Nach dieser Ausrichtung wird das Bauteil 20 mit einem Tropfen einer sich verfestigenden Flüssigkeit vergossen. Der Brechungsindex dieser sich verfestigenden Flüssigkeit ist so gewählt, daß eine gute optische Kopplung zwischen dem Wellenleiter 12 und dem elektrooptischen Bauteil 20 erhalten wird. Nach Verfestigung der Flüssigkeit ist das elektrooptische Bauteil in seiner Stellung zu dem Wellenleiter fixiert. Es ist gegen äußere Einflüsse geschützt und praktisch mit in das Substrat 10 eingebettet. Der verfestigte Tropfen bildet über dem Bauteil 20 einen Hügel 30. Dieser Hügel 30 schließt auch die Bonddrähte 22 und 24 und deren Verbindung mit den Bondkontakten mit ein.

Als Material zum Vergießen der elektrooptischen Bauteile kann ein Kunstharz oder ein Silikonkautschuk dienen. In der Ausführung von Fig. 1 und 2 ist das elektrooptische Bauteil 20 ein photoelektrischer Empfänger, beispielsweise eine Photodiode. Dieser photoelektrische Empfänger ist auf einem Chip montiert, der z.B. Vorverstärker enthält. Statt eines photoelektrischen Empfängers kann auch eine Leuchtdiode in der gleichen Weise montiert werden.

Fig.3 und 4 zeigen die Anbringung eines Lasers 32 nach im wesentlichen dem gleichen Verfahren. Entsprechende Teile sind mit den gleichen Bezugszeichen versehen wie in Fig. 1 und 2. Der Laser 32 weist eine Wärmesenke 34 auf. Der Laser 32 mit der Wärmesenke 34 ist kopfstehend so montiert, daß die blockförmige Wärmesenke 34 mit ihrer den Laser tragenden Seitenfläche auf der Oberfläche 36 des Substrats 10 aufliegt. Der Laser 32 ragt in die geätzte Grube 18. Der Laser wird zu

dem Wellenleiter 12 justiert. Dann wird die Wärmesenke 34 mit der Oberfläche 36 verklebt. Schließlich wird wieder die gesamte Anordnung einschließlich der Bonddrähte 22 und 24 mit einer sich verfestigenden Flüssigkeit vergossen.

Bei der Ausführung nach Fig .5 ist eine Grube 40 in der Oberfläche 36 des Substrats 10 durch mechanische Bearbeitung, nämlich durch Bohren, hergestellt. Die Grube 40 schneidet dabei, ähnlich wie in Fig. 1, den Wellenleiter 12 an. In die Grube 40 wird eine Photodiode 42 eingesetzt. Die Photodiode 42 ist wesentlich größer als der Wellenleiter 12. Daher ergibt sich auch bei einem Abstrahlwinkel von beispielsweise 200 an der Stirnfläche des Wellenleiters 12 noch ein guter Empfangswirkungsgrad der Photodiode 42. Durch das Ausfüllen mit einer Vergußmasse 44 in Form eines niedrigbrechenden Klebers wird der Abstrahlwinkel zusätzlich verkleinert. Die Photodiode 42 ist Teil eines Chips 46. Der Chip 46 sitzt schräg zur Oberfläche 36 des Substrats 10 und der Grube 40. Zum elektrischen Anschluß wird die Chipvorderseite 48 mit einem Bonddraht 50 normal gebondet. Auf die Chiprückseite 52 wird ein Bonddraht 54 mit Leitsilber geklebt. Als äußere Bondstützpunkte dienen stehengelassene Inseln der Substratmaskierung, wie oben beschrieben. Es können für diesen Zweck auch Dünnfilmelektroden nachträglich aufgebracht werden.

Bei der Ausführung nach Fig .6 ist ein Laserchip 56 mit einem Laser 58 und einer Wärmesenke 60 "kopfstehend" in einer Grube 62 in der Oberfläche des Substrats 10 angeordnet. Der Laser 58 wird dabei mittels eines Mikromanipulators zu der Stirnfläche des Wellenleiters 12 justiert. Während der Justage wird die Einkoppelincensität des Lasers 58 in den Wellenleiter 12 kontrolliert. Die Justage erfolgt so, daß diese Einkoppelintensität möglichst optimiert wird. Da bei der Ankopplung eines Lasers Fehler in der Oberfläche der Grube 62 wesentlich schwerer wiegen als bei der Ankopplung einer Photodiode, muß der Abstand zwischen dem Laser 58 und der Stirnfläche des Wellenleiters 12 sehr klein gehalten werden. Bei einer durch Bohren oder Ätzen erhaltenen Grube von etwa 0 3 mm Durchmesser kann ein Abstand von 5 um realisiert werden.

In der so gefundenen Position muß der Laser 58 fixiert werden. Dabei darf der Laserchip nicht beschädigt werden. Auch sollte sich der Brechungsindexsprung und damit das Reflexionsvermögen der Endflächen des Lasers 58 nicht ändern. Aus diesem Grund wird bei der Ausführung nach Fig .6 der Laser 58 nur an der Wärmesenke 60 mittels der Vergußmasse 64 verklebt. Der Laser 58 selbst ist in der Grube 62 unter Lufteinschluß verkapselt.

Als Vergußmasse dient ein niedrigbrechender, optischer, UV-gestarteter Kleber.

Die Ausführung nach Fig.7 ist ähnlich wie die Ausführung nach Fig.6. Entsprechende Teile tragen die gleichen Bezugszeichen wie in Fig.6.

Bei der Ausführungsform nach Fig .7 ist die Grube 66 von einer Querfräsung gebildet. Wie aus Fig.8 und 9 ersichtlich ist, ist die Querfräsung 66 zylinderabschnitt förmig. Die Querfräsung 66, zu deren Herstellung ein kleiner Scheibenfräser quer zur Richtung des Wellenleiters 12 bewegt wird, weist zwei zueinander parallele, ebene, zur Oberfläche 36 des Substrats 10 und zu der Richtung des Wellenleiters 12 senkrechte Stirnflächen 68 und 70 auf. zwischen den Seitenflächen 68 und 70 erstreckt sich, wie aus Fig .8 ersichtlich ist, eine zylindrische Boden- und Wandungsfläche 72 der Querfräsung 66.

Bei einer solchen Querfräsung ist es möglich, den Abstand des Lasers 58 von dem Wellenleiter auf etwa 2 um zu reduzieren.

Zur Herstellung einer in integrierter Optik aufgebauten Laseranordnung, bei welcher der Laser mit einem externen Resonanzraum arbeitet, wird der Laser 32 in der Grube 18 voll vergossen, wie das in Fig. 10 dargestellt ist. Damit ist die vordere Facette des Lasers 32 über die Vergußmasse, die einen an den Brechungsindex des Wellenleiters angepaßten Brechungsindex besitzt, mit dem Wellenleiter gekoppelt. Es ist dann aber erforderlich, die rückwärtige Fläche 74 des Lasers 32 zu verspiegeln. Eine solche Anordnung kann benutzt werden zum Aufbau eines Rotationssensors, wie er in der EP-A1-0 290 723 beschrieben ist. Der Wellenleiter 12 ist zu einem in Fig. 10 schematisch dargestellten externen Spiegel 76 geführt.

Bei der Ausführung nach Fig. 10 ist die Grube 18 ebenfalls durch Ätzen hergestellt. Zu diesem Zweck ist die Oberfläche 36 des Substrats 10 um den vorgesehenen Ort der Grube 18 herum mit einer gegenüber dem Ätzmittel widerstandsfähigen Schicht 78 abgedeckt. Die Schicht 78 kann beispielsweise von einem Ätzstopplack gebildet sein. Der Ätzvorgang wird dann so gesteuert, daß eine "Unterätzung" stattfindet. Das Ätzmittel frißt sich in den Bereich unter der Schicht 78 hinein. Es entsteht ein Überhang 80 am oberen Rand der Wandung der Grube 18 dicht unterhalb der Schicht 78. Der Wellenleiter 12 ist in den Bereich dieses Überhanges 80 geführt. Das erleichtert es, den Laser 32 dicht vor dem Ende des Wellenleiters 12 anzuordnen.

In ähnlicher Weise kann natürlich auch die Grube für ein anderes elektrooptisches Bauteil ausgebildet und hergestellt werden.

Fig.11 und 12 zeigen ebenfalls eine Anordnung mit einem Laser 58 in integrierter Optik, der einen externen Resonanzraum aufweist.

Der Laser 58 sitzt ebenfalls "kopfstehend" in einer Grube. Die Wärmesenke 60 ist sitzt auf der Oberfläche 36 des Substrats 10. Die Grube ist eine Querfräsung ähnlich der von Fig .7 bis 9. Im Gegensatz zu der Anordnung nach den Figuren 7 bis 9 ist der Laser 58 bei der Anordnung nach Fig. 11 und 12 mit der sich verfestigenden Flüssigkeit 82 vergossen. Die dem Wellenleiter 12 abgewandte, rückwärtige Fläche des Lasers 58 ist mit einer Verspiegelung 84 versehen. Weiterhin wird der Resonanzraum durch eine Verspiegelung 86 begrenzt, die auf eine Endfläche des aus Glas bestehenden Substrats 10 aufgebracht ist. Der Wellenleiter 12 ist zu dieser verspiegelten Endfläche geführt.

## Ansprüche

1. Verfahren zum Anbringen von elektrooptischen Bauteilen an integriertoptischen Wellenleitern, die an einem Substrat vorgesehen sind, **gekennzeichnet durch die Verfahrensschritte:**

(a) Herstellen einer Grube, die einen Wellenleiter anschneidet, in der Oberfläche des Substrats,

(b) Positionieren und Haltern eines zu montierenden elektrooptischen Bauteils in der Grube in der gewünschten Position zu dem· Wellenleiter und

(c) Vergießen des Bauteils in der Grube mit einem sich verfestigenden Material.

2. Verfahren nach Anspruch 1, **dadurch gekennzeichnet, daß** zum Herstellen der Grube ein Ätzmittel auf die Oberfläche des Substrats aufgebracht wird.

3. Verfahren nach Anspruch 2, **dadurch gekennzeichnet, daß** das Substrat (10) Glas und das Ätzmittel Flußsäure ist.

4. Verfahren nach einem der Ansprüche 2 oder 3, **dadurch gekennzeichnet, daß**

(a) auf die Oberfläche des Substrats um den Bereich der Grube herum eine von dem Ätzmittel nicht angegriffene Schicht aufgebracht wird,

(b) der Ätzvorgang so durchgeführt wird, daß eine Unterätzung stattfindet, derart, daß die Grube unterhalb der besagten Schicht einen überhängenden Wandungsteil aufweist, und

(c) der Wellenleiter in diesem überhängenden Wandungsteil endet.

5. Verfahren nach Anspruch 1, **dadurch gekennzeichnet, daß** die Grube durch mechanische Bearbeitung des Substrats hergestellt wird.

6. Verfahren nach Anspruch 5, **dadurch gekennzeichnet, daß** die Grube durch Bohren hergestellt wird.

7. Verfahren nach Anspruch 5, **dadurch gekennzeichnet, daß** die Grube durch Fräsen hergestellt wird.

8. Verfahren nach Anspruch 7, **dadurch gekenn-**

zeichnet, daß mit einem Fräswerkzeug eine zylinderabschnittförmige Grube mit zwei zueinander parallelen, ebenen Stirnflächen senkrecht zur Oberfläche des Substrats gefräst wird.

9. Verfahren nach einem der Ansprüche 1 bis 8, **dadurch gekennzeichnet, daß** das sich verfestigende Material ein Kunstharz ist.

10. Verfahren nach einem der Ansprüche 1 bis 8, **dadurch gekennzeichnet, daß** das sich verfestigende Material Silikonkautschuk ist.

11. Verfahren nach einem der Ansprüche 1 bis 8, **dadurch gekennzeichnet, daß** das sich verfestigende Material ein niedrigbrechender, optischer, UV-gestarteter Kleber ist.

12. Verfahren nach einem der Ansprüche 1 bis 11, **dadurch gekennzeichnet, daß** bei der Herstellung der Wellenleiter (12) durch Ionenaustausch, wobei die Oberfläche (36) des Substrats durch eine Metallschicht abgedeckt und diese Metallschicht nach Herstellung der Wellenleiter (12) weggeätzt wird, neben der Position der zu montierenden elektrooptischen Bauteile (20) Teile der Metallschicht vor dem Wegätzen abgedeckt werden, so daß die so stehenbleibenden Teile der Metallschicht Bondkontakte bilden, mit denen Bonddrähte (22,24) der elektrooptischen Bauteile (20) verbunden werden.

13. Verfahren nach einem der Ansprüche 1 bis 12, **dadurch gekennzeichnet, daß**

    (a) das elektrooptische Bauteil ein Laserchip (32) mit einer Wärmesenke (34) ist und

    (b) der Laserchip (32) kopfstehend mit der Wärmesenke (34) so auf das Substrat (10) aufgeklebt wird, daß er in den Wellenleiter (12) einstrahlt.

14. Verfahren nach Anspruch 13, **dadurch gekennzeichnet, daß**

    (a) der Laser mittels eines Mikromanipulators positioniert wird und

    (b) bei der Positionierung die Einkopplungsintensität des Lasers beobachtet wird.

15. Verfahren nach Anspruch 13 oder 14, **dadurch gekennzeichnet, daß** der Laser nur an der Wärmesenke verklebt und unter Lufteinschluß verkapselt wird.

16. Verfahren nach Anspruch 11 oder 12, **dadurch gekennzeichnet, daß** zur Herstellung einer integrierten Optik mit einem Laser mit externem Resonanzraum der Laser zur Teilentspiegelung im Bereich seiner vorderen Facette mit einer Vergußmasse umgossen wird, deren Brechungsindex an den Brechungsindex des Wellenleiters angepaßt ist.

17. Verfahren nach Anspruch 15, **dadurch gekennzeichnet, daß** zur Herstellung einer integrierten Optik mit einem Laser mit externem Resonanzraum der Laser auf seiner Rückseite verspiegelt und der Wellenleiter zu einem externen Spiegel geführt wird.

18. Verfahren nach Anspruch 17, **dadurch gekennzeichnet, daß** zur Bildung des externen Spiegels eine Endfläche des Substrats verspiegelt wird, zu welcher der Wellenleiter führt.

19. Verfahren nach einem der Ansprüche 1 bis 12, **dadurch gekennzeichnet, daß** das elektrooptische Bauteil eine Photodiode aufweist.

20. Verfahren nach einem der Ansprüche 1 bis 12, **dadurch gekennzeichnet, daß** das elektrooptische Bauteil eine Leuchtdiode aufweist.

Fig. 1

Fig. 2

Fig. 3

Fig. 4

Fig. 5

Fig. 6

Fig. 7

Fig. 8

Fig. 9

Fig. 10

Fig. 11

Fig. 12

11